(19) Europäisches Patentamt
European Patent Office
Office européen des brevets

(11) **EP 4 653 831 A1**

(12) **EUROPEAN PATENT APPLICATION**

(43) Date of publication:
26.11.2025 Bulletin 2025/48

(21) Application number: 25174679.8

(22) Date of filing: 07.05.2025

(51) International Patent Classification (IPC):
**G01K 7/01** (2006.01)  **G01K 7/32** (2006.01)

(52) Cooperative Patent Classification (CPC):
**G01K 7/01; G01K 7/32;** G01K 2219/00

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: 21.05.2024 US 202418669794

(71) Applicant: **STMicroelectronics International N.V.**
**1228 Plan-les-Ouates, Geneva (CH)**

(72) Inventors:
• **CIMAZ, Lionel**
**35137 PLEUMELEUC (FR)**
• **TURCONI, Clara**
**20044 ARESE (IT)**

(74) Representative: **Casalonga**
**Casalonga & Partners**
**Bayerstraße 71/73**
**80335 München (DE)**

(54) **TEMPERATURE SENSOR USING A CONTROLLED OSCILLATOR**

(57)    Apparatuses, systems, and methods for temperature sensors are provided, including temperatures sensors using a controlled oscillator. An exemplary temperature sensor may comprise: a clock generating circuit comprising: a bandgap circuit to generate a first input signal that varies based on a temperature; a first controlled oscillator configured to receive the first input signal and generate a first clock signal; a first counter configured to receive the first clock signal and a first enable signal, wherein the first counter generates a first count signal based on the first clock signal and the first enable signal; a processor and a non-transitory memory including computer coded instructions, the computer coded instructions, with the processor, cause the processor to: determine the temperature based at least on the first count signal; and generate a temperature signal based at least on the temperature, wherein the temperature signal is a binary signal.

FIG. 1

Processed by Luminess, 75001 PARIS (FR)

**Description**

TECHNOLOGICAL FIELD

Example embodiments of the present disclosure relate generally to temperature sensors, particularly to temperatures sensors using a controlled oscillator.

BACKGROUND

Temperature sensors that provide temperature in a digital output format may be used in many applications. Conventional approaches for generating a temperature signal in a digital format include an analog circuit or electrical component that is sensitive to the temperature and that is used to provide a signal (e.g., a voltage signal and/or a current signal) that is proportional to the temperature. This signal from a temperature sensitive analog circuitry or electrical component is converted to the digital temperature using an Analog-to-Digital Convertor (ADC). An example of such a conventional approach includes a digital temperature sensor that generates a current signal applied to a resistor that changes resistance based on temperature. A voltage measurements associated with the resistor is, thus, temperature sensitive. This voltage measurement is input into an ADC that generates a digital output signal of the temperature in a digital format.

Such convention approaches, however, require an ADC. There are many disadvantages when using such an ADC. For example, an ADC may not be available. Alternatively or additionally, using an ADC may increase space requirements, weight, energy consumption, complexity, and/or the cost of a circuit. Moreover, an ADC may itself be sensitive to temperature and, thus, reduce the accuracy of temperature measurement. Additionally or alternatively, a resistor in conventional approaches may further exhibit nonlinear behavior based on the temperature, which may prevent a linear measurement of the temperature.

The inventors have identified numerous areas of improvement in the existing technologies and processes, which are the subjects of embodiments described herein. Through applied effort, ingenuity, and innovation, many of these deficiencies, challenges, and problems have been solved by developing solutions that are included in embodiments of the present disclosure, some examples of which are described in detail herein.

BRIEF SUMMARY

Various embodiments described herein relate to temperature sensors, particularly to temperatures sensors using a controlled oscillator.

In accordance with some embodiments of the present disclosure, an example temperature sensor is provided. The example temperature sensor may comprise: a clock generating circuit comprising: a bandgap circuit configured to generate a first input signal that varies based on a temperature; one or more controlled oscillators including a first controlled oscillator configured to receive the first input signal and generate a first clock signal; one or more counters including a first counter configured to receive the first clock signal from the clock generating circuit and a first enable signal for a first time period, wherein the first counter is further configured to generate at least a first count signal based at least on the first clock signal and the first enable signal; at least one processor and at least one non-transitory memory including computer coded instructions thereon, the computer coded instructions, with the at least one processor, cause the processor to: determine the temperature based at least on the first count signal; and generate a temperature signal based at least on the temperature, wherein the temperature signal is a binary signal.

In some embodiments, a value of the first count signal during the first time period is an exponential power of 2.

In some embodiments, to determine the temperature based at least on the first count signal the computer coded instructions, with the at least one processor, further cause the processor to perform a binary shift of the first count signal.

In some embodiments, the first enable signal is based on a reference clock signal.

In some embodiments, the temperature sensor further comprises a clock divider, and wherein a reference clock signal is provided to the clock divider to generate the first enable signal.

In some embodiments, the computer coded instructions, with the at least one processor, further cause the processor to generate the first enable signal.

In some embodiments, the first input signal is linearly dependent based on a temperature.

In some embodiments, the first input signal varies proportionally to absolute temperature or varies negatively-proportionally to absolute temperature.

In some embodiments, the bandgap circuit is further configured to generate a second input signal that varies based on the temperature; wherein the one or more controlled oscillators include a second controlled oscillator configured to receive the second input signal and generate a second clock signal; wherein the one or more counters include a second counter configured to receive the second clock signal from the clock generating circuit and the first enable signal, wherein the second counter is further configured to generate at least a second count signal based at least on the second clock signal and the first enable signal; and wherein to determine the temperature based at least on the first count signal and the second count signal.

In some embodiments, to determine the temperature is further based at least on a gamma signal and an offset signal.

In accordance with some embodiments of the present disclosure, an example method is provided. The example method may comprise: generating, with a clock generating circuit, a first clock signal, wherein generating the first clock signal comprises: generating, with a bandgap circuit, a first input signal, wherein the first input signal varies based on a temperature; receiving the first input signal at a first controlled oscillator of one or more controlled oscillators; generating the first clock signal with the first controlled oscillator based on the first input signal; receiving, at a first counter of one or more counters, the first clock signal and a first enable signal for a first time period; generating, with the first counter, a first count signal based at least on the first clock signal and the first enable signal; determining the temperature based at least on the first count signal; and generating a temperature signal based at least on the temperature, wherein the temperature signal is a binary signal.

In some embodiments, a value of the first count signal during the first time period is an exponential power of 2.

In some embodiments, determining the temperature based at least on the first count signal the computer coded instructions comprises a binary shift of the first count signal.

In some embodiments, the first enable signal is based on a reference clock signal.

In some embodiments, the method further comprises generating, by a clock divider, the first enable signal based on the reference clock signal.

In some embodiments, the method further comprises generating, by a processor, the first enable signal, and wherein generating the temperature signal is by the processor.

In some embodiments, the first input signal is linearly dependent based on a temperature.

In some embodiments, the first input signal varies proportionally to absolute temperature or varies negatively-proportionally to absolute temperature.

In some embodiments, the method further comprises: generating, with the clock generating circuit, a second clock signal, wherein generating the second clock signal comprises: generating, with the bandgap circuit, a second input signal, wherein the second input signal varies based on the temperature; receiving the second input signal at a second controlled oscillator of the one or more controlled oscillators; generating a second clock signal with the second controlled oscillator based on the second input signal; receiving, at a second counter of one or more counters, the second clock signal and the first enable signal for a first time period; generating, with the second counter, a second count signal based at least on the second clock signal and the first enable signal; and wherein determining the temperature is further based at least on the second count signal.

In some embodiments, determining the temperature based at least on the first count signal is further based at least on a gamma signal and an offset signal.

The above summary is provided merely for purposes of summarizing some example embodiments to provide a basic understanding of some aspects of the disclosure. Accordingly, it will be appreciated that the above-described embodiments are merely examples and should not be construed to narrow the scope or spirit of the disclosure in any way. It will also be appreciated that the scope of the disclosure encompasses many potential embodiments in addition to those here summarized, some of which will be further described below.

BRIEF SUMMARY OF THE DRAWINGS

Having thus described certain example embodiments of the present disclosure in general terms, reference will now be made to the accompanying drawings, which are not necessarily drawn to scale, and wherein:

FIG. 1 illustrates an exemplary diagram of a controlled oscillator 100 in accordance with one or more embodiments of the present disclosure;

FIG. 2 illustrates an exemplary diagram of a double clock generating circuit 200 in accordance with one or more embodiments of the present disclosure;

FIG. 3 illustrates an exemplary diagram of a double clock generating circuit 300 in accordance with one or more embodiments of the present disclosure;

FIG. 4 illustrates an exemplary diagram of a single clock generating circuit 400 in accordance with one or more embodiments of the present disclosure;

FIG. 5 illustrates a first exemplary temperature sensor in accordance with one or more embodiments of the present disclosure;

FIG. 6 illustrates a second exemplary temperature sensor in accordance with one or more embodiments of the present disclosure;

FIG. 7 illustrates a third exemplary temperature sensor in accordance with one or more embodiments of the present disclosure;

FIG. 8 illustrates a flowchart of exemplary operations for a temperature sensor in accordance with one or more embodiments of the present disclosure; and

FIG. 9 illustrates an exemplary device in accordance with one or more embodiments of the present disclosure.

DETAILED DESCRIPTION

Some embodiments of the present disclosure will now be described more fully herein with reference to the accompanying drawings, in which some, but not all, embodiments of the disclosure are shown. Indeed, various embodiments of the disclosure may be embodied in many different forms and should not be construed as limited to the embodiments set forth herein; rather, these embodiments are provided so that this disclosure will satisfy applicable legal requirements. Like reference numerals refer to like elements throughout.

As used herein, the term "comprising" means including but not limited to and should be interpreted in the manner it is typically used in the patent context. Use of broader terms such as comprises, includes, and having should be understood to provide support for narrower terms such as consisting of, consisting essentially of, and comprised substantially of.

The phrases "in various embodiments," "in one embodiment," "according to one embodiment," "in some embodiments," and the like generally mean that the particular feature, structure, or characteristic following the phrase may be included in at least one embodiment of the present disclosure and may be included in more than one embodiment of the present disclosure (importantly, such phrases do not necessarily refer to the same embodiment).

The word "example" or "exemplary" is used herein to mean "serving as an example, instance, or illustration." Any implementation described herein as "exemplary" is not necessarily to be construed as preferred or advantageous over other implementations.

If the specification states a component or feature "may," "can," "could," "should," "would," "preferably," "possibly," "typically," "optionally," "for example," "often," or "might" (or other such language) be included or have a characteristic, that a specific component or feature is not required to be included or to have the characteristic. Such a component or feature may be optionally included in some embodiments or it may be excluded.

The use of the term "circuitry" as used herein with respect to components of a system or an apparatus should be understood to include particular hardware configured to perform the functions associated with the particular circuitry as described herein. The term "circuitry" should be understood broadly to include hardware and, in some embodiments, software for configuring the hardware. For example, in some embodiments, "circuitry" may include processing circuitry, communications circuitry, input/output circuitry, and the like. In some embodiments, other elements may provide or supplement the functionality of particular circuitry.

Exemplary Apparatuses, Systems, and Methods

Various embodiments of the present disclosure are directed to improved temperature sensors. Temperature sensing has application in a myriad of applications, including in various apparatuses, systems, and methods. These applications may utilize a temperature sensor that generates a temperature as a digital signal of one or more values, which may be referred to, among other things, as a temperature digital signal. For example, various embodiments provide a binary value of a temperature. This binary value may be associated with any of the temperature scales, such as Celsius, Fahrenheit, Kelvin, etc. In various embodiments, the temperature digital signal may be used for temperature correction and/or temperature compensation, which may be based on the temperature sensed. Various embodiments of the present disclosure include improved temperature sensing.

Various embodiments of the present disclosure generate one or more signals that are used to generate a temperature digital signal. The temperature sensors of the various embodiments of the present disclosure may include a temperature sensor that includes a bandgap circuit and one or more controlled oscillators.

A bandgap circuit may be used to generate a first current (Ip) that is Positively-proportional To Absolute Temperature (PTAT) and a second current (In) that is Negatively-proportional To Absolute Temperature (NTAT). The sum of Ip and In (i.e., Ip+In) may be a constant value. This may be described by the following equations:

$$I_p = k.\,T + I_0$$

Eq. 1

$$I_n = -k.\,T + I_1$$

Eq. 2

where T is the temperature, $I_0$ is a constant value of a first current before temperature variation, $I_1$ is constant value before temperature variation, and k is a coefficient of the bandgap circuit that is determined as:

$$k = \gamma.\,(I_0 + I_1)$$

Eq. 3

where y is a constant value.

In various embodiments, the sensitivity to the temperature may be cancelled when Ip and In are added to each other, which results in: Ip + In = $I_0$ + $I_1$. The bandgap circuit generates both Ip and In, and the temperature T may be extracted from Ip and/or In.

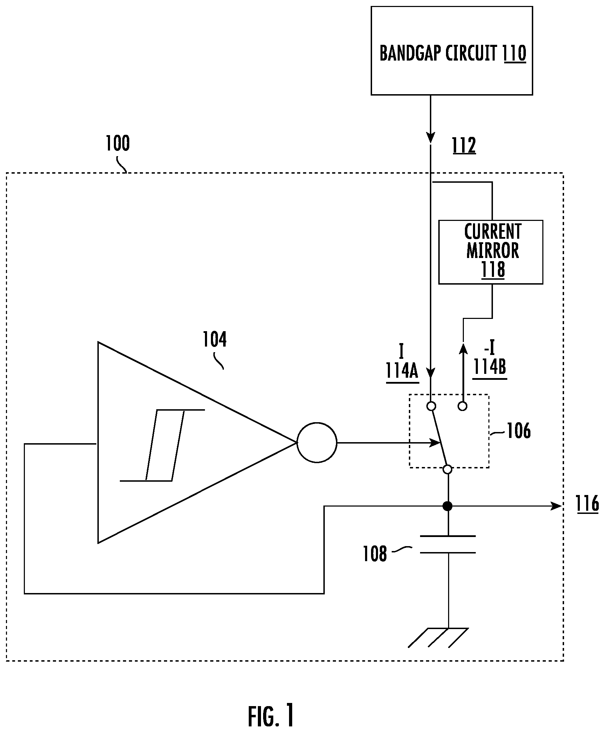

FIG. 1 illustrates an exemplary diagram of a controlled oscillator 100 in accordance with one or more embodiments of the present disclosure. The controlled oscillator 100 is controlled using an input signal 112 generated by and provided from a bandgap circuit 110. The input signal 112 may be, for example, a current signal. The controlled oscillator 100 may generate an output signal 116. The current of the input signal 112 may control the controlled oscillator 100 to generate an output signal 116 with a specific frequency, which may be a clock signal. Thus the frequency of the output signal 116 may be based on the current of the input signal 112.

The controlled oscillator 100 may include a Schmidt trigger inverter 104, a switch 106, a capacitor 108, and a current mirror 118. A voltage of the capacitor 108 is fed back to an input of the Schmidt trigger inverter 104. The Schmidt trigger inverter 104 drives a switch 106. Depending on the state of the Schmidt trigger inverter 104, capacitor 108 is charged with an oscillator input current (I) 114A or discharged with negative oscillator input current (-I) 114B. The Schmidt trigger inverter 104 toggles the switch with a frequency F as the capacitor is charged and discharged, which causes the Schmidt trigger inverter 104 to toggle and, thus, toggle the switch 106. The frequency is linear with the input signal 112 and does not have an offset.

The controlled oscillator 100 is controlled using an oscillator input current (I) 114A and a negative oscillator input current (-I) 114B. The oscillator input current (I) 114A may be the same signal as the input signal 112. The negative oscillator input current (-I) 114B is the negative of the oscillator input current (I) 114A and, thus, may have an inverse polarity of the oscillator input current (I) 114A. In various embodiments, the negative oscillator input current (-I) 114B may be generated from the oscillator input current (I) 114A using a current mirror 118 or an inverter circuit.

In various embodiments, the oscillator input current (I) 112 may be the first current ($I_P$) generated by the bandgap circuit 110. Thus the negative oscillator input current (-I) 114B may be an inverted Ip (e.g., -Ip). This negative oscillator input current (-I) 114B of an inverted Ip may be generated from input signal 112 of Ip generated by the bandgap circuit 110 that is passed through a current mirror 118 or an inverter circuit.

Alternatively, in various embodiments, the oscillator input current (I) 114A may be the second current ($I_n$) generated by the bandgap circuit 110. Thus the negative oscillator input current (-I) 114B may be an inverted In (e.g., -$I_n$). This negative oscillator input current (-I) 114B of an inverted In may be generated from input signal 112 of In generated by the bandgap circuit 110 that is passed through a current mirror 118 or an inverter circuit.

The controlled oscillator 100 may generate an output signal 116. In various embodiments, a frequency of the output signal 116 is linearly proportional to the oscillator input current (I) 114A without any offset, which may also be described as the output signal 116 being directly proportional to the oscillator input current (I) 114A. For example, the frequency F of the output signal 116 may be generated may be determined with the following equation:

$$F = \frac{I}{2.\,C.\,V_{hyst}}$$

Eq. 4

where C is the capacitance value of the capacitor 108, and Vhyst is a hysteresis voltage of the Schmidt trigger inverter 104. In various embodiments Vhyst may be a constant value.

In various embodiments, the gain of the controlled oscillator 100 is inversely proportional to C and to Vhyst. For example, the gain may be determined using:

$$G = \frac{1}{2.\,C.\,V_{hyst}}.$$

Eq. 5

In various embodiments, since the input signal 112, which is input to the controlled oscillator 100 as oscillator input current (I) 114A, varies based on temperature, the frequency F of output signal 116 varies based on temperature.

For example, when Ip is used as the input signal 112 to control the controlled oscillator 100, as the temperature increases then Ip increases and the frequency F of the output signal 116 also increases. This increase in the frequency F of the output signal also falls with a fall in temperature.

For another example, when In is used as the input signal 112 to control the controlled oscillator 100, as the temperature increases then In decreases and the frequency F of the output signal 116 also decreases. This decrease in the frequency F of the output signal also rises with a rise in temperature.

In various embodiments, the output signal 116 of the controlled oscillator 100 may be used as a clock signal.

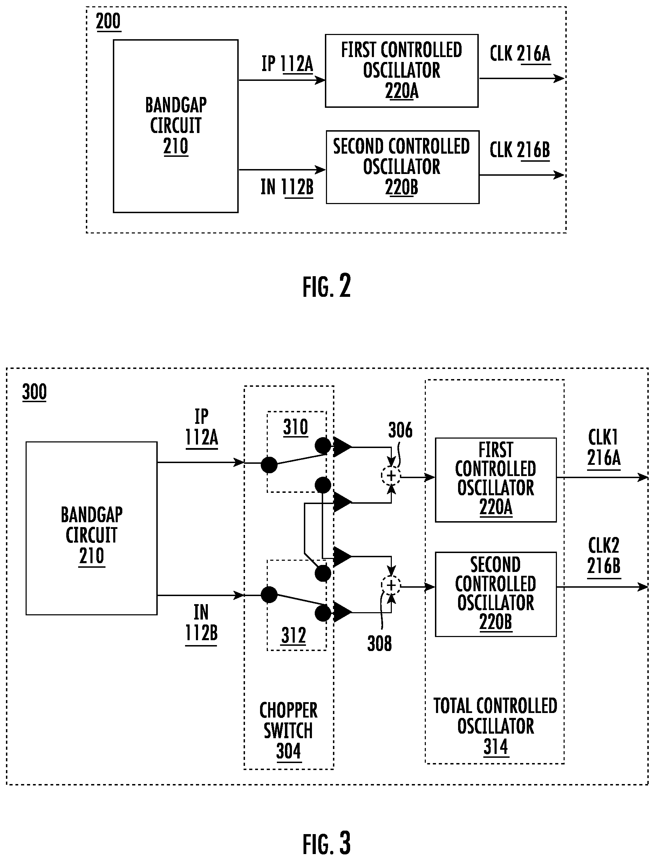

FIG. 2 illustrates an exemplary diagram of a double clock generating circuit 200 in accordance with one or more embodiments of the present disclosure. In various embodiments, the double clock generating circuit 200 includes a bandgap circuit 210, a first controlled oscillator 220A generating a first clock signal (CLK1) 216A, and a second controlled oscillator 220B generating a second clock signal (CLK2) 216B.

The bandgap circuit 210 may generate two signals: Ip and In. The Ip signal may be a first input signal (Ip) 112A provided to a first controlled oscillator 220A. The In signal may be a second input signal (In) 112B provided to a second controlled oscillator 220B. The first controlled oscillator 220A may generate a first clock signal (CLK1) 216A based on a first input signal (Ip) 112A. The second controlled oscillator 220B may generate a second clock signal (CLK2) 216B based on second input signal (In) 112B. Thus, in various embodiments, the first clock signal (CLK1) 216A has a frequency that rises as temperature increases and the second clock signal (CLK2) 216B has a frequency that falls as temperature increases.

The double clock generating circuit 200 may provide for a conversion of a temperature at two frequencies-a first clock signal (CLK1) 216A having a first frequency (F1) and a second clock signal (CLK2) 216B having the second frequency (F2). The first frequency (F1) of the first clock signal (CLK1) 216A and the second frequency (F2) of the second clock signal (CLK2) 216B are each dependent on the temperature and may be used to generate a temperature value in a digital form as described herein.

In various embodiments, a counter may be used to count a number of cycles of the first clock signal (CLK1) 216A and/or second clock signal (CLK2) 216B for a first period of time. The count(s) may be used to determine the temperature in a digital form, such as with a binary value.

With one bandgap circuit 210 generating a first input signal (Ip) 112A and a second input signal (In) 112B, both of the first input signal (Ip) 112A and the second input signal (In) 112B have the same coefficient k (e.g., Eqs. 1 & 2).

The double clock generating circuit 200 includes two controlled oscillators 220 (e.g., 220A, 220B) and, thus, a gain of each of the controlled oscillators 220 may be different. These difference in gain may be due to, for example, different characteristics of the circuitry and/or electrical components in each of the respective controlled oscillators 200. In various embodiments, the frequency of a controlled oscillator 220 (e.g., 220A, 220B) is based on, among other things, the gain of the controlled oscillator 220. For example, a frequency (F1) of the first clock signal (CLK1) 216A may be directly proportional to the first input signal (Ip) 112A based on a gain (G1) of the first controlled oscillator 220A. Similarly, a frequency (F2) of the second clock signal (CLK2) 216B may be directly proportional to the second input signal (In) 112B based on a gain (G2) of the second controlled oscillator 220B.

In various embodiments, to counter a difference between a first gain (G1) and a second gain (G2), a chopper switch may be used as described herein.

FIG. 3 illustrates an exemplary diagram of a double clock generating circuit 300 in accordance with one or more embodiments of the present disclosure. The double clock generating circuit 300 may include a bandgap circuit 210, a chopper switch 304, a first adder 306, a second adder 308, and a total controlled oscillator 314. The total controlled oscillator 314 may include a first controlled oscillator 220A and a second controlled oscillator 220B.

The chopper switch 304 may be configured to route the first input signal (Ip) 112A either to first controlled oscillator 220A or second controlled oscillator 220B. The chopper switch 304 may be configured to route the second input signal (In) 112B to either first controlled oscillator 220A or second controlled oscillator 220B. The routing of the first input signal (Ip) 112A and the second input signal (In) 112B may be by a first switch 310 and/or a second switch 312 of the chopper switch 304.

The first switch 310 is configured to receive first input signal (Ip) 112A at a first input terminal of the chopper switch 304 and output the received first input signal (Ip) 112A to either of a first output terminal or a third output terminal of the chopper switch 304.

The second switch 312 is configured to receive second input signal (In) 112B at a second input terminal of the chopper switch 304 and output the received second input signal (In) 112B to either of a second output terminal or a fourth output terminal of the chopper switch 304.

In various embodiments, the first switch 310 is configured to route the first input signal (Ip) 112A to either the first controlled oscillator 220A or the second controlled oscillator 220B, and the second switch 312 is configured to route second input signal (In) 112B to either the first controlled oscillator 220A or second controlled oscillator 220B.

The double clock generating circuit 300 may include a first adder 306 and a second adder 308.

The output from the chopper switch 304 provided to the first adder 306 may be either the first input signal (Ip) 112A or the second input signal (In) 112B based on a current state of the chopper switch 304. The first adder 306 is configured to provide a summation of an output from the chopper switch 304. The summation generated by the first adder 306 is provided to the first controlled oscillator 220A of the total controlled oscillator 314.

The output from the chopper switch 304 provided to the second adder 308 may be either the first input signal (Ip) 112A or the second input signal (In) 112B based on a current state of the chopper switch 304. The second adder 308 is configured to provide a summation of an output from the chopper switch 304. The summation generated by the second adder 308 is provided to the second controlled oscillator 220B of the total controlled oscillator 314.

In various embodiments, the chopper switch 304 may change configurations or states to change the routing of signals in different time periods. For example, for a first period of time, chopper switch 304 routes first input signal (Ip) 112A to the first controlled oscillator 220A and second input signal (In) 112B to the second controlled oscillator 220B. For a second period of time chopper switch 304 switches second input signal (In) 112B to the first controlled oscillator 220A and first input signal (Ip) 112A to the second controlled oscillator 220B.

By measuring a temperature over a period of time comprising the first period and the second period, a disparity between the gains G1 and G2 is averaged out. In various embodiments, G1 + G2 may be referred to as Gt, which may be the gain of the total controlled oscillator 314. A difference of the frequency of the first clock signal (CLK1) 216A and second clock signal (CLK2) 216B may be referred to as a frequency difference ($\Delta F$). This frequency difference is directly proportional to Gt. A summation of the frequencies of first clock signal (CLK1) 216A and second clock signal (CLK2) 216B may be referred to as frequency summation ($\Sigma F$). The frequency summation is also directly proportional to Gt.

For example:

$$\Delta F = 2 . G_t . k . T + G_t(I_0 - I_1)$$

and

$$\Sigma F = G_t(I_0 + I_1).$$

Eq. 6

In Eq. 6 above, certain of the variables are known, such as $k, I_0$, and $I_1$.

In various embodiments, a division of the $\Delta F$ with $\Sigma F$ is determined, which may be referred to as delta-sum frequency divided (Fdiv):

$$F_{div} = \frac{\Delta F}{\Sigma F} = 2 . \gamma . T + 1 - \frac{2 . I_1}{I_{ref}}$$

and

$$I_{ref} = I_0 + I_1$$

Eq. 7

In Eq. 7 above: for a particular bandgap circuit, $\gamma$ is a known value; and $I_1$ and $I_{ref}$ may be measured for the bandgap circuit. By measuring $I_0$ and $I_1$ from the bandgap circuit, and using the known value y of the bandgap circuit, the temperature T may be measured using $\Delta F/\Sigma F$. In some examples, the known value y is constant for any bandgap circuit and $I_0$ and $I_1$ are specific for the bandgap circuit.

In various embodiments, the term of Eq. 7 of -1 + 2 * $I_1$ / $I_{ref}$ may be referred to as an offset. Thus Eq. 7 may be rewritten as:

$$\frac{\Delta F}{\Sigma F} = 2 . \gamma . T - Offset$$

Eq. 8

Rearranging Eq. 8 to determine to results in:

$$T = \frac{1}{2 . \gamma}[\frac{\Delta F}{\Sigma F} + Offset]$$

Eq. 9

For a bandgap circuit $\gamma$ is known and Eq. 9 may be simplified to:

$$T = \frac{\Delta F . gamma}{\Sigma F} + Offset$$

Eq. 10

In Eq. 10, gamma is set to 662/2, which equates to 1/ (2. $\gamma$). As described herein, and in accord with Eq. 10, when the offset is provided, gamma is provided, $\Delta F$ is provided, and $\Sigma F$ is provided, then a temperature may be determined. From the temperature determined, a temperature signal may generated, including a binary temperature signal.

In various embodiments, one or more devices, such as but not limited to a microcontroller, processor, or the like, may receive the first clock signal (CLK1) 216A and second clock signal (CLK2) 216B from the controlled oscillator. The one or more computing devices may determine the frequency of first clock signal (CLK1) 216A (e.g., a first frequency) and the frequency of second clock signal (CLK2) 216B (e.g., a second frequency). The one or more devices may determine a frequency summation ($\Sigma F$) of the first frequency and the second frequency and also a frequency difference ($\Delta F$) of the first frequency and the second frequency. The one or more devices may determine Fdiv by dividing $\Delta F$ by $\Sigma F$, such as described in Eq. 7 above. The determination of temperature (T) may include utilizing measured values $I_0$ and $I_1$, known value of $\gamma$, and determined value Fdiv. Some of these values may be received as described herein.

The temperature (T) may be a linear function of $\Delta F/\Sigma F$, such as described in Eq. 7. In such a linear function of temperature (T), the slope of the determined temperature (T) function is directly proportional to y and an offset of 1 - (2 * $I_1$ / $I_{ref}$). This offset depends on $I_0$ and $I_1$ as $I_{ref}$ equals $I_0$ and $I_1$. This offset is specific to a particularly bandgap circuit. In various embodiments, the particular values of gamma ($\gamma$) and the offset may be determine during calibration of the device and/or circuitry. During fabrication there may be differences between devices, such as due to fabrication, manufacturing, or the like. The devices may be calibrated to identify values associated with these differences, such as gamma ($\gamma$) and the offset.

In various embodiments, the temperature signal generated may be based on the temperature determined, which is based on the first clock signal (CLK1) 216A and second clock signal (CLK2) 216B. The temperature signal is in a digital format.

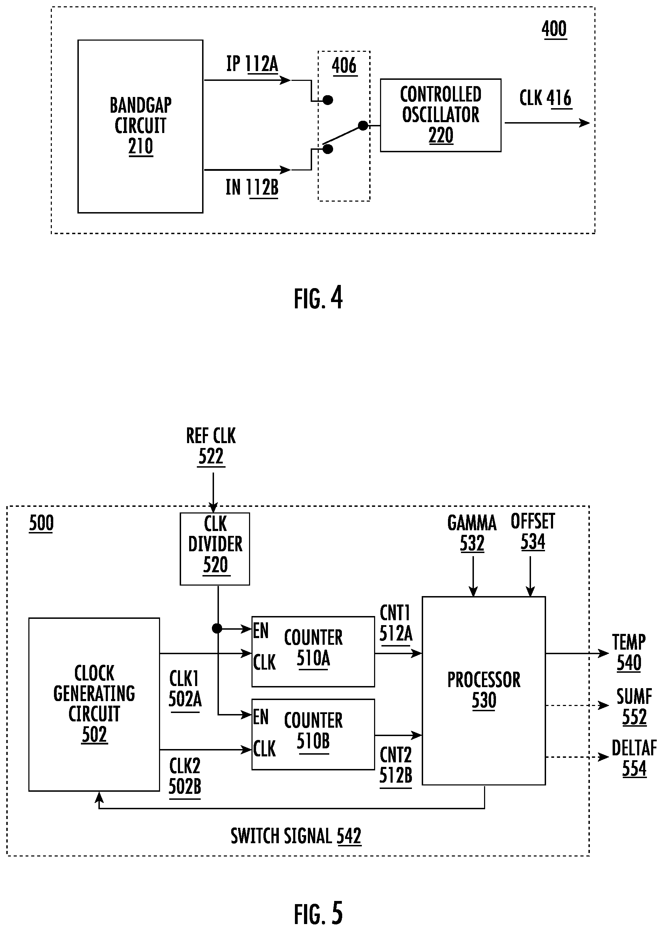

FIG. 4 illustrates an exemplary diagram of a single clock generating circuit 400 in accordance with one or more embodiments of the present disclosure. The single clock generating circuit 400 includes a bandgap circuit 210, a switch 406, and a controlled oscillator 220.

In various embodiments where there may be less temperature variation (e.g., due to a higher temperature stability), simultaneous acquisition of first input signal (Ip) 112A and second input signal (In) 112B may not be required. In such embodiments, a clock generating circuit may be configured by using one controlled oscillator 220.

In the single clock generating circuit 400 the switch 406 may be configured to alternate between a first state and a second state. In the first state the switch 406 may provide first input signal (Ip) 112A to the controlled oscillator 220. In the second state the switch 406 may provide second input signal (In) 112B to the controlled oscillator 220. The switch may be operated to change between the first state and the second state. The controlled oscillator 220 is configured to generate a clock signal (CLK) 416 having a clock frequency. The clock frequency of the clock signal (CLK) 416 is dependent on the signal routed from the bandgap circuit 210 to the controlled oscillator 220, which is the first input signal (Ip) 112A when switch 406 in a first state and the second input signal (In) 112B when the switch 406 is in a second state.

In various embodiments, one or more computing devices may determine a temperature using the frequency of clock signal(s) generated (e.g., 216A, 216B, 416). Since the frequency of the clock signal(s) depends on first input signal (Ip) 112A and/or second input signal (In) 112B at a moment in time and/or during a time period and since first input signal (Ip) 112A and/or second input signal (In) 112B are dependent on temperature, the frequency of the clock signal is dependent on the temperature.

FIG. 5 illustrates a first exemplary temperature sensor in accordance with one or more embodiments of the present disclosure. The first exemplary temperature sensor 500 may include a clock generating circuit 502, a one or more counters 510, a clock divider 520, and a processor 530.

The clock generating circuit 502 may be, for example, one of the clock generating circuits described herein (e.g., 200, 300). The clock generating circuit 502 may generate a first clock signal 502A and a second clock signal 502B. In various embodiments, the first clock signal 502A may be first clock signal (CLK1) 216A, and the second clock signal 502B may be second clock signal (CLK2) 216B (or vice-versa). The first clock signal 502A may be provided to a first counter 510A as an input clock signal into the first counter 510A. The second clock signal 502B may be provided to a second counter 510B as a input clock signal into the second counter 510B.

Each of the first counter 510A and the second counter 510B may receive an enable signal (EN). In various embodiments, the enable signal (EN) may be provided from the clock divider 520.

The first counter 510A may count the number of clock cycles in a first clock signal 502A during an enable period. For example, during a first time period associated with the enable signal (EN) the first counter 510A may count the number of zero crossings or another portion of the first clock signal 510A. The first counter 510A may count the number of cycles in the received first clock signal 502A and generate a first count signal (CNT1) 512A. The first count signal (CNT1) 512A may be a digital signal (e.g., binary) associated with the number of cycles counted by the first counter 510A.

The second counter 510B may count the number of clock cycles in a second clock signal 502B during an enable period. For example, during a first time period associated with the enable signal (EN) the second counter 510B may count the number of zero crossings or another portion of the second clock signal 510B. The second counter 510B may count the number of cycles in the received second clock signal 502B and generate a second count signal (CNT2) 512B. The second count signal (CNT2) 512B may be a digital signal (e.g., binary) associated with the number of cycles counted by the second counter 510B.

The enable signal provided to each of the first counter 510A and the second counter 510B may be the same enable signal. Alternatively, the enable signal for the first counter 510A and the enable signal for the second counter 510B may be different signals.

The enable signal provided to the first counter 510A and to the second counter 510B may be generated by a clock divider 520. The clock divider 522 may receive a reference clock signal 522 and divide the reference clock signal 522 to generate the enable signal. The clock divider 520 may be configured to generate an enable signal associated with one or more periods of times. These one or more time periods may be associated with generating count signals associated across multiple time periods, which may allow for determining temperatures over time and also generating temperature signals for different time periods. Various embodiments may omit a clock divider 522 when the reference clock signal 522 is associated with one or more time periods and a clock divider 522 is not needed.

A processor 530 may receive a first count signal (CNT1) 512A and second count signal (CNT2) 512B as well as other signals to generate, among other things, a temperature signal 540. In various embodiments, the processor 530 may receive a gamma signal 532 and an offset signal 534. Gamma is a constant that is associated with a bandgap circuit of the first exemplary temperature sensor 500. The offset may be particular for a temperature sensor, but may change between temperature sensors. Thus the gamma and the offset may be determined via calibration.

The gamma signal 532 may be an analog or digital signal that is associated with a value of gamma. The value of gamma may be measured and/or determined with one or more calibration operations. In various embodiments, the value of gamma may be stored in memory and provided to the processor 530 with a gamma signal 532 when performing one or more operations to generate a temperature signal 540. In various embodiments, once provided, the gamma value may be used by the processor 530 in subsequent operations.

The offset signal 534 may be an analog or digital signal that is associated with a value of an offset. The value of an offset may be measured and/or determined with one or more calibration operations. In various embodiments, the value of the offset may be stored in memory and provided to the processor 530 with an offset signal when performing one or more operations to generate a temperature signal 540. In various embodiments, once provided, the offset value may be used by the processor 530 in subsequent operations.

The processor 530 may determine a temperature and generate a temperature signal 540. The temperature may be determined as described herein. The temperature signal 540 generated may be a digital signal associated with the temperature determined. In various embodiments, the temperature signal 540 may be based on the first count signal (CNT1) 512A, the second count signal (CNT2) 512B, the gamma signal 534, and the offset signal 534.

In various embodiments, a switch signal 542 may be generated by the processor 530 and provided to control a chopper switch (e.g., 304). The switch signal 542 may be used to control, for example, which of the first input signal (Ip) 112A and first input signal (In) 112B is provided to which controlled oscillator (e.g., 220A, 220B).

In various embodiments, the processor may generate a SUMF signal 552 and a DELTAF signal 554. For example, the SUMF signal 552 and the DELTAF signal may be generated during one or more calibration operations. These calibrations operations may be utilized to, for example, generate and/or store these values in memory, such as the value of gamma and/or the value of the offset.

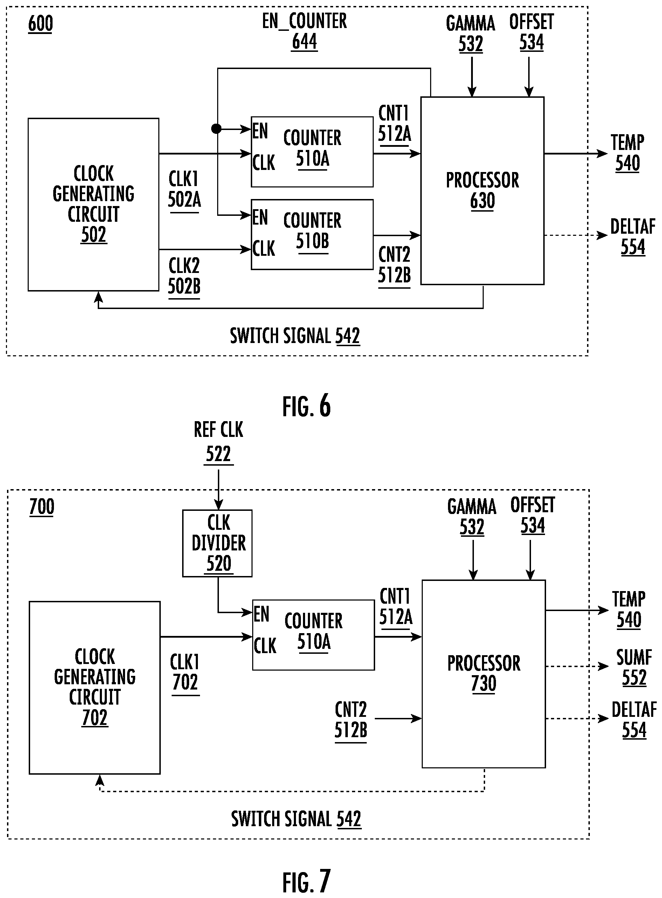

FIG. 6 illustrates a second exemplary temperature sensor in accordance with one or more embodiments of the present disclosure. The second exemplary temperature sensor 600 may include a clock generating circuit 502, a one or more counters 510, and a processor 630.

One or more portions of the second exemplary temperature sensor 600 may be similar and/or different from the first exemplary temperature sensor 500. For example, the clock generating circuit 502, first clock signal 502A, second clock signal 502B, first counter 510A, second counter 510B, first count signal (CNT1) 512A, second count signal (CNT2) 512B, gamma signal 532, offset signal 534, temperature signal 540, and/or switch signal 542, may be the same, such as described herein, or may be different.

In the second exemplary temperature sensor 600, the processor 630 may generate an enable signal (EN_COUNTER) 644 that is provided to one or more of the counters 510. The enable signal (EN_COUNTER) 644 may be associated with one or more time periods for the counters 510 to performing their counting the cycles of a received clock signal 502.

FIG. 7 illustrates a third exemplary temperature sensor in accordance with one or more embodiments of the present disclosure. The third exemplary temperature sensor 700 may include a clock generating circuit 702, a one or more counters 510, a clock divider 520, and a processor 730.

One or more portions of the third exemplary temperature sensor 700 may be similar and/or different from the first exemplary temperature sensor 500 and/or the second exemplary temperature sensor 600. For example, the first counter 510A, first count signal (CNT1) 512A, second count signal (CNT2) 512B, gamma signal 532, offset signal 534, temperature signal 540, switch signal 542, SUMF signal 552, and/or DELTAF signal 554 may be the same, such as described herein, or may be different.

The clock generating circuit 702 may be, for example, a clock generating circuit that generates one or more clock signals 702 (e.g., 512A, 512B). In various embodiments, the clock generating circuit 702 may generate a signal clock signal 702 (e.g., 416). In various embodiments, the clock generating circuit 702 may generate more than one clock signal (e.g., 216A, 216B) and only one clock signal 702 may be used.

The processor 730 may be similar or different to the processor in other embodiments (e.g., 530), such a by receiving gamma signal 532, offset signal 534 and generating a temperature signal 540, switch signal 542, SUMF signal, and DELTAF 554. The processor 730 may also receive a first count signal 512A and second count signal 512B. The second count signal 512B may be set to a constant. In various embodiments, this constant may be zero. In various embodiments, the second count signal 512B signal may be associated with a zero value or may be an open circuit and the processor 730 may be configured to utilize such as a zero value. In such embodiments, the third exemplary temperature sensor 700 may operate as if it is only one clock signal (e.g., 702) instead of two clock signals.

In various embodiments, the processor (e.g., 530, 730) may be a calculation machine that is comprised of hardware and/or circuitry to perform one or more operations described herein. The processor (e.g., 530, 730) may perform division using hardware and not software, such as with one or more operations described herein.

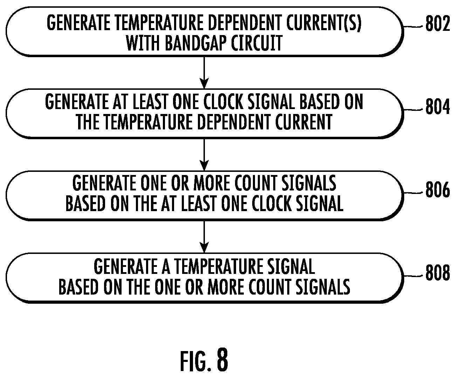

FIG. 8 illustrates a flowchart of exemplary operations for a temperature sensor in accordance with one or more embodiments of the present disclosure.

At operation 802, a bandgap circuit may generate temperature dependent current(s). In various embodiments, the bandgap circuit may generate a first temperature dependent current with a first input signal (Ip) 112A and a second temperature dependent current with a second input signal (In) 112B. These first input signal (Ip) 112A and second input signal (In) 112B may, as described herein, be dependent on temperature. In various embodiments, the bandgap circuit may only generate a first temperature dependent current with a first input signal (Ip) 112A.

At operation 804, generate at least one clock signal based on the temperature dependent current(s). A clock generating circuitry (e.g., 200, 300, 400) may generate at least one clock signal based on the temperature dependent current. The first input signal (Ip) 112A and/or second input signal (In) 112A may be provided to a first controlled oscillator and/or a second controlled respectively, which is described herein. In various embodiments, the first controlled oscillator 220A may generate a first clock signal and the second controlled oscillator 220B may generate a second clock signal. In various embodiments a clock generating circuitry may include or use only a first controlled oscillator 220A to generate a first clock signal 216A.

In generating at least one clock signal, the clock generating circuit may utilize a switch signal 542 to operate a switch, such as a chopper switch 304 or switch 406. The switch signal 542 may be generated by the processor (e.g., 530, 730).

In various embodiments the chopper switch may be operated based on a switch signal 542, which may be generated by a processor (e.g., 530, 730). The switch 542 may be utilized by the chopper switch 304 to control providing a first input signal (Ip) 112A to a first controlled oscillator 220A and a second input signal (In) 112B to a second controlled oscillator 220B during a first time period. In various embodiments, and during a second time period, the chopper switch 304 may be operated to provide the first input signal (Ip) 112A to the second controlled oscillator 220B and provide the second input signal (In) 112B to the first controlled oscillator 220A. Thus the same signal may be provided to each of the controlled oscillators, which may allow for determining and/or cancelling out of variations specific one or both controlled oscillators over two periods of time, such as described herein.

In various embodiments the switch 406 may be operated by the switch signal 542 to selected which of a first input signal (Ip) 112A or second input signal (In) 112B is provided to a controlled oscillator 220.

At operation 806, generate one or more count signals based on the at least one clock signal.

In various embodiments, each clock signal 502 provided to a counter 510 may be counted during a time period associated with an enable signal. A counter 510 may count, for example, the number of cycles in a clock signal within a period of time. The value of the counts is provided as an output in a count signal 512 generated counter. The count signal 512 may be a digital signal, such as a binary signal.

In various embodiments with more than one counter 510, the counters 510 may be run at the same time. This may allow for, for example, counting a first clock signal 502A with a first counter 510A and counting a second clock signal 502B with a second counter 510B. As the first clock signal 502A may be generated by a first controller oscillator (e.g., 220A) of a clock generating circuit 502) and the second clock signal 502B may be generated by a second controlled oscillator (e.g., 220B of a clock generating circuit 502), will be counting and/or measuring clock signals from separate controlled oscillators (e.g., 220A and 220B) simultaneously, which may include counting and/or measurements of signals having any error or variations associated with these separate controlled oscillators (e.g., 220A and 220B).

In various embodiments, combining count signals over multiple periods of time may average out one or more errors associated with controller oscillator 220 when a chopper switch 304 may switch which first input signal (Ip) 112A and/or second input signal (In) 112B each controlled oscillator 220A, 220B utilizes to generate the clock signal 216A, 216B, which are then provided to the counters 510A, 510B.

For example, in a first time period associated with a first enable signal, a first counter 510A may generate a first count signal 512A based on a first clock signal 216A and a second counter 510B may generate a second count signal 510B based on a second clock signal 216B.

The first clock signal 216A may have been generated by the first controlled oscillator 220A based on the first input signal (Ip) 112A provided to the first controlled oscillator 220A by the chopper switch 304. Thus, the first count signal 512A for this first time period may be associated with the first input signal (Ip) 112A and the first controlled oscillator 220A for this first time period.

The second clock signal 502B may have been generated by the second controlled oscillator 220B based on the second input signal (In) 112B provided to the second controlled oscillator 220B by the chopper switch 304. The second count signal 512B for this first time period may be associated with the second input signal (In) 112B and the second controlled oscillator 220B for this first time period.

At the end of the first time period, and before the second time period, the enable signal may be changed to stop the first time period, the chopper switch 304 may receive an updated switch signal 542 to operate the chopper switch 304, and a second enable signal for the second time period may be provided.

In a second time period associated with a second enable signal, the chopper switch may be operated to provide the first input signal (Ip) 112A to the second controlled oscillator 220B and to provide the second input signal (In) 112B to the first controlled oscillator 220A.

In this second time period, the first clock signal 216A may have been generated by the first controlled oscillator 220A based on the second input signal (In) 112B provided to the first controlled oscillator 220A by the chopper switch 304. Thus, the first count signal 512A for this second time period may be associated with the second input signal (In) 112B and the first controlled oscillator 220A for this second time period.

Also in the second time period, the second clock signal 502B may have been generated by the second controlled oscillator 220B based on the first input signal (Ip) 112A provided to the second controlled oscillator 220B by the chopper switch 304. The second count signal 512B for this second time period may be associated with the first input signal (Ip) 112A and the second controlled oscillator 220B for this second time period.

Over this first time period and the second time period, the respective count signals may be summed to allow for averaging out of any fabrication errors or the like. As both the first input signal (Ip) 112A and second input signal (In) 112B signals are associated with a one of the counts from each of the counters 510A, 510B over the two time periods, any fabrication errors or the like in the respective chains to generate these signals are reflected in the counts that are summed together.

In various embodiments, the enable signal may be based on a reference clock (e.g., 522) and/or an enable signal 644 that may be generated by a processor (e.g., 630).

At operation 808, generate a temperature signal based on the at least one clock signal.

The processor (e.g., 530, 630. 730) may generate a temperature signal 540 based on first count signal (CNT1) 512A, second count signal (CNT2) 512B, gamma signal 532, and offset signal 534.

In various embodiments, this processor may not perform a division operation and may instead perform a binary shift operation. With a fixed point configuration, a binary shift operation that shifts a first binary signal to generate a shifted binary signal. The shifted binary equates to a value of the first binary signal divided by 2 to the power of n, where n is the number of bits shifted in the binary shift. For example, if n is equal to 1 in the binary shift then one binary bit is shifted, which equates to a value of the shifted binary signal equaling the value of the first binary signal divided by 2. As a further example, if n is equal to 2 in the binary shift then two binary bits are shifted, which equates to a value of the shifted binary signal equaling the value of the first binary signal divided by 4. For example, if n is equal to 8 in the binary shift then eight binary bits are shifted, which equates to a value of the shifted binary signal equaling the value of the first binary signal divided by 256.

In various embodiments, by generating an enable signal associated with a time period in which a sum of the first count signal and the second count signal equal to 2 to the power n, a binary shift operation may be used to perform an operation that is the same as dividing by sum of the first count signal and the second count signal. Thus with such a binary shift operation the determination of a temperature and generation of a temperature signal 540 may be performed without utilizing a division operation.

In various embodiments, because the enable signal(s) are associated with a frequency summation (ΣF) equal to an exponential power of 2, a binary shift operation may be performed instead of dividing by a frequency summation (ΣF). So the enable signal allows for the counters 510 to operate while the sum of the counters is not equal to a power of $2^n$ (e.g., 1024) so that the binary shift operation may subsequently be used to divide by such a power of $2^n$. In various embodiments, the removal of the division operation provides improvements, including by removing a division operation that conventionally may be difficult to perform or approximate.

The difference in first count signal (CNT1) 512A and second count signal (CNT2) 512B may be determined by a subtraction operation to generate a frequency difference (ΔF).

As described herein, herein with at least Eq. 10, such a binary shift operation along with first count signal (CNT1) 512A, second count signal (CNT2) 512B, gamma signal 532, and offset signal 534allows for the determination of a temperature and also the generation of a temperature signal.

In various embodiments, once a temperature sensor is fabricated, manufactured, or the like, calibration may be performed at one or more set temperatures to determine the value(s) of one or more parameters of the temperature sensor, such as the value of gamma and/or the value of an offset. To determine these values one or more SUMF signal 552 and/or one or more DELTAF signal(s) 554 may be measured at one or more temperatures. The values of gamma and/or the offset may be determined from these signals, such as in accord with equations described herein. These parameters may be specific to the temperature sensor. These parameters may be stored in the temperature sensor, such as in memory, and may be provided for use in determining temperature(s) during operation.

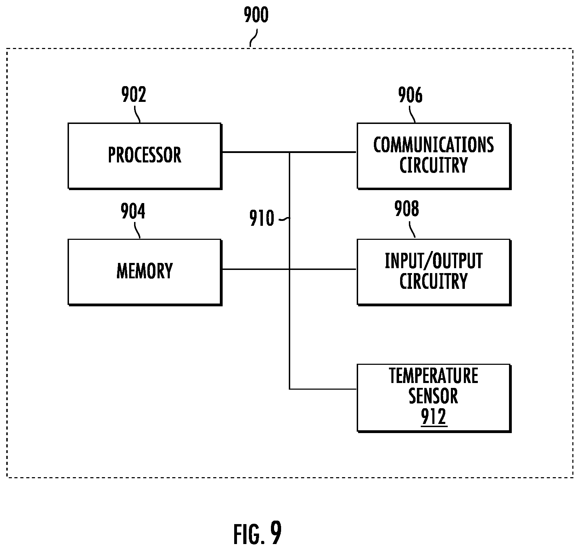

FIG. 9 illustrates an exemplary device in accordance with one or more embodiments of the present disclosure. The device 900 illustrated may be a system and/or apparatus that includes a processor 902, memory 904, communications circuitry 906, input/output circuitry 908, temperature sensor 912, and all of which may be connected by a bus or buses 910. The device 900 may be, for example, a chip or the like. The temperature sensor 912 may be a temperature sensor as described herein (e.g., 500, 600 700) or the like. While such connections are illustrated as bus 910, it will be readily appreciated that there may be multiple other connections.

The processor 902, although illustrated as a single block, may be comprised of a plurality of components and/or processor circuitry. The processor 902 may be implemented as, for example, various components comprising a state-based state machine, one or a plurality of microprocessors with accompanying digital signal processors; one or a plurality of processors without accompanying digital signal processors; one or a plurality of coprocessors; one or a plurality of multi-core processors; processing circuits; and various other processing elements. The processor may include integrated circuits. In various embodiments, the processor 902 may be configured to execute applications, instructions, and/or programs stored in the processor 902, memory 904, or otherwise accessible to the processor 902. When executed by the processor 902, these applications, instructions, and/or programs may enable the execution of one or a plurality of the operations and/or functions described herein. Regardless of whether it is configured by hardware, firmware/software methods, or a combination thereof, the processor 902 may comprise entities capable of executing operations and/or functions according to the embodiments of the present disclosure when correspondingly configured.

In various embodiments, the processor 902 may be the same or different from a processor of the temperature sensor (e.g., 530, 630, 730).

The memory 904 may comprise, for example, a volatile memory, a non-volatile memory, or a certain combination thereof. The memory 904 may be non-transitory memory. Although illustrated as a single block, the memory 904 may comprise a plurality of memory components. In various embodiments, the memory 904 may comprise, for example, a random access memory, a cache memory, a flash memory, a hard disk, a circuit configured to store information, or a combination thereof. The memory 904 may be configured to write or store data, information, application programs, instructions, etc. so that the processor 904 may execute various operations and/or functions according to the embodiments of the present disclosure. For example, in at least some embodiments, a memory 904 may be configured to buffer or cache data for processing by the processor 902. Additionally or alternatively, in at least some embodiments, the memory 904 may be configured to store program instructions for execution by the processor 902. The memory 904 may store information in the form of static and/or dynamic information. When the operations and/or functions are executed, the stored information may be stored and/or used by the processor 902.

The communication circuitry 906 may be implemented as a circuit, hardware, computer program product, or a combination thereof, which is configured to receive and/or transmit data from/to another component or apparatus. The computer program product may comprise computer-readable program instructions stored on a computer-readable medium (e.g., memory 904) and executed by a processor 902. In various embodiments, the communication circuitry 906 (as with other components discussed herein) may be at least partially implemented as part of the processor 902 or otherwise controlled by the processor 902. The communication circuitry 906 may communicate with the processor 902, for example, through a bus 910. Such a bus 910 may connect to the processor 902, and it may also connect to one or more other components of the processor 902. The communication circuitry 906 may be comprised of, for example, transmitters, receivers, transceivers, network interface cards and/or supporting hardware and/or firmware/software, and may be used for establishing communication with another component(s), apparatus(es), and/or system(s). The communication circuitry 906 may be configured to receive and/or transmit data that may be stored by, for example, the memory 904 by using one or more protocols that can be used for communication between components, apparatuses, and/or systems.

The input/output circuitry 908 may communicate with the processor 902 to receive instructions input by an operator and/or to provide audible, visual, mechanical, or other outputs to an operator. The input/output circuitry 908 may comprise supporting devices, such as a keyboard, a mouse, a user interface, a display, a touch screen display, lights (e.g., warning lights), indicators, speakers, and/or other input/output mechanisms. The input/output circuitry 908 may comprise one or more interfaces to which supporting devices may be connected. In various embodiments, aspects of the input/output circuitry 908 may be implemented on a device used by the operator to communicate with the processor 902. The input/output circuitry 908 may communicate with the memory 904, the communication circuitry 906, and/or any other component, for example, through a bus 910.

It should be readily appreciated that the embodiments of the apparatuses, systems, and methods described herein may be configured in various additional and alternative manners in addition to those expressly described herein.

Conclusion

Operations and/or functions of the present disclosure have been described herein, such as in flowcharts. As will be appreciated, computer program instructions may be loaded onto a computer or other programmable apparatus (e.g., hardware) to produce a machine, such that the resulting computer or other programmable apparatus implements the operations and/or functions described in the flowchart blocks herein. These computer program instructions may also be stored in a computer-readable memory that may direct a computer, processor, or other programmable apparatus to operate and/or function in a particular manner, such that the instructions stored in the computer-readable memory produce an article of manufacture, the execution of which implements the operations and/or functions described in the flowchart blocks. The computer program instructions may also be loaded onto a computer, processor, or other programmable apparatus to cause a series of operations to be performed on the computer, processor, or other programmable apparatus to produce a computer-implemented process such that the instructions executed on the computer, processor, or other programmable apparatus provide operations for implementing the functions and/or operations specified in the flowchart blocks. The flowchart blocks support combinations of means for performing the specified operations and/or functions and combinations of operations and/or functions for performing the specified operations and/or functions. It will be understood that one or more blocks of the flowcharts, and combinations of blocks in the flowcharts, can be implemented by special purpose hardware-based computer systems which perform the specified operations and/or functions, or combinations of special purpose hardware with computer instructions.

While this specification contains many specific embodiments and implementation details, these should not be construed as limitations on the scope of any disclosures or of what may be claimed, but rather as descriptions of features specific to particular embodiments of particular disclosures. Certain features that are described herein in the context of separate embodiments can also be implemented in combination in a single embodiment. Conversely, various features that are described in the context of a single embodiment can also be implemented in multiple embodiments separately or in any suitable subcombination. Moreover, although features may be described above as acting in certain combinations and even initially claimed as such, one or more features from a claimed combination can in some cases be excised from the combination, and the claimed combination may be directed to a subcombination or variation of a subcombination.

While operations and/or functions are illustrated in the drawings in a particular order, this should not be understood as requiring that such operations and/or functions be performed in the particular order shown or in sequential order, or that all illustrated operations be performed, to achieve desirable results. In certain circumstances, operations and/or functions in alternative ordering may be advantageous. In some cases, the actions recited in the claims may be performed in a different order and still achieve desirable results. Thus, while particular embodiments of the subject matter have been described, other embodiments are within the scope of the following claims.

While this detailed description has set forth some embodiments of the present invention, the appended claims cover other embodiments of the present invention which differ from the described embodiments according to various modifications and improvements.

Within the appended claims, unless the specific term "means for" or "step for" is used within a given claim, it is not intended that the claim be interpreted under 35 U.S.C. § 112, paragraph 6.

## Claims

1. A temperature sensor comprising:

    ◦ a clock generating circuit comprising:

        • a bandgap circuit configured to generate a first input signal that varies based on a temperature;
        • one or more controlled oscillators including a first controlled oscillator configured to receive the first input signal and generate a first clock signal;

    ◦ one or more counters including a first counter configured to receive the first clock signal from the clock generating circuit and a first enable signal for a first time period, wherein the first counter is further configured to generate at least a first count signal based at least on the first clock signal and the first enable signal;
    ◦ at least one processor and at least one non-transitory memory including computer coded instructions thereon, the computer coded instructions, with the at least one processor, cause the processor to:

        • determine the temperature based at least on the first count signal; and
        • generate a temperature signal based at least on the temperature, wherein the temperature signal is a binary signal.

2. The temperature sensor of claim 1, wherein a value of the first count signal during the first time period is an exponential power of 2.

3. The temperature sensor of claim 2, wherein to determine the temperature based at least on the first count signal the computer coded instructions, with the at least one processor, further cause the processor to perform a binary shift of the first count signal.

4. The temperature sensor of claim 1, wherein the first enable signal is based on a reference clock signal.

5. The temperature sensor of claim 5 further comprising a clock divider, and wherein a reference clock signal is provided to the clock divider to generate the first enable signal.

6. The temperature sensor of claim 1, wherein the computer coded instructions, with the at least one processor, further cause the processor to generate the first enable signal.

7. The temperature sensor of claim 1, wherein the first input signal is linearly dependent based on a temperature.

8. The temperature sensor of claim 7, wherein the first input signal varies proportionally to absolute temperature or varies negatively-proportionally to absolute temperature.

9. The temperature sensor of claim 1, wherein the bandgap circuit is further configured to generate a second input signal that varies based on the temperature;

wherein the one or more controlled oscillators include a second controlled oscillator configured to receive the second input signal and generate a second clock signal;

wherein the one or more counters include a second counter configured to receive the second clock signal from the clock generating circuit and the first enable signal, wherein the second counter is further configured to generate at least a second count signal based at least on the second clock signal and the first enable signal; and

wherein to determine the temperature based at least on the first count signal and the second count signal.

10. The temperature sensor of claim 1, wherein to determine the temperature is further based at least on a gamma signal and an offset signal.

11. A method comprising:

generating, with a clock generating circuit, a first clock signal, wherein generating the first clock signal comprises:

generating, with a bandgap circuit, a first input signal, wherein the first input signal varies based on a temperature;
receiving the first input signal at a first controlled oscillator of one or more controlled oscillators;
generating the first clock signal with the first controlled oscillator based on the first input signal;

receiving, at a first counter of one or more counters, the first clock signal and a first enable signal for a first time period;
generating, with the first counter, a first count signal based at least on the first clock signal and the first enable signal;
determining the temperature based at least on the first count signal; and
generating a temperature signal based at least on the temperature, wherein the temperature signal is a binary signal.

12. The method of claim 11, wherein a value of the first count signal during the first time period is an exponential power of 2.

13. The method of claim 12, wherein determining the temperature based at least on the first count signal the computer coded instructions comprises a binary shift of the first count signal.

14. The method of claim 11, wherein the first enable signal is based on a reference clock signal.

15. The method of claim 11 further comprising: generating, by a clock divider, the first enable signal based on the reference clock signal.

16. The method of claim 11 further comprising generating, by a processor, the first enable signal, and wherein generating the temperature signal is by the processor.

17. The method of claim 11, wherein the first input signal is linearly dependent based on a temperature.

18. The method of claim 11, wherein the first input signal varies proportionally to absolute temperature or varies negatively-proportionally to absolute temperature.

19. The method of claim 11 further comprising:

generating, with the clock generating circuit, a second clock signal, wherein generating the second clock signal comprises:

generating, with the bandgap circuit, a second input signal, wherein the second input signal varies based on the temperature;
receiving the second input signal at a second controlled oscillator of the one or more controlled oscillators;
generating a second clock signal with the second controlled oscillator based on the second input signal;

receiving, at a second counter of one or more counters, the second clock signal and the first enable signal for a first time period;
generating, with the second counter, a second count signal based at least on the second clock signal and the first enable signal; and
wherein determining the temperature is further based at least on the second count signal.

20. The method of claim 11, wherein determining the temperature based at least on the first count signal is further based at least on a gamma signal and an offset signal.

FIG. 1

FIG. 2

FIG. 3

FIG. 4

FIG. 5

**FIG. 6**

**FIG. 7**

GENERATE TEMPERATURE DEPENDENT CURRENT(S) WITH BANDGAP CIRCUIT —802

GENERATE AT LEAST ONE CLOCK SIGNAL BASED ON THE TEMPERATURE DEPENDENT CURRENT —804

GENERATE ONE OR MORE COUNT SIGNALS BASED ON THE AT LEAST ONE CLOCK SIGNAL —806

GENERATE A TEMPERATURE SIGNAL BASED ON THE ONE OR MORE COUNT SIGNALS —808

FIG. 8

900

902

| PROCESSOR |

904

| MEMORY |

906

| COMMUNICATIONS CIRCUITRY |

910

908

| INPUT/OUTPUT CIRCUITRY |

| TEMPERATURE SENSOR 912 |

FIG. 9

## EUROPEAN SEARCH REPORT

**Application Number**

EP 25 17 4679

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2024/142316 A1 (KIM HANSEUL [KR] ET AL) 2 May 2024 (2024-05-02) * paragraph [0034] - paragraph [0168]; figures 1-26 * | 1-20 | INV. G01K7/01 G01K7/32 |
| X | US 2023/119770 A1 (CAO CHI [CN] ET AL) 20 April 2023 (2023-04-20) * paragraph [0018] - paragraph [0043]; figures 1-7 * | 1-20 | |
| X | US 2019/056274 A1 (FAN PHILEX MING-YAN [GB] ET AL) 21 February 2019 (2019-02-21) * paragraph [0018] - paragraph [0063]; figures 1-4 * | 1-20 | |

**TECHNICAL FIELDS SEARCHED (IPC)**

G01K

The present search report has been drawn up for all claims

| Place of search | Date of completion of the search | Examiner |
|---|---|---|
| The Hague | 3 October 2025 | Rosello Garcia, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 17 4679

This annex lists the patent family members relating to the patent documents cited in  the above-mentioned European search report.
The members are as contained in the European Patent Office EDP file on
The European Patent Office is in no way liable for these particulars which are merely given for the purpose of information.

03-10-2025

| Patent document cited in search report | Publication date | Patent family member(s) | | Publication date |
|---|---|---|---|---|
| US 2024142316 A1 | 02-05-2024 | CN | 117949109 A | 30-04-2024 |
| | | KR | 20240061132 A | 08-05-2024 |
| | | US | 2024142316 A1 | 02-05-2024 |
| US 2023119770 A1 | 20-04-2023 | CN | 113834578 A | 24-12-2021 |
| | | US | 2023119770 A1 | 20-04-2023 |
| US 2019056274 A1 | 21-02-2019 | US | 2019056274 A1 | 21-02-2019 |
| | | WO | 2019036543 A1 | 21-02-2019 |

EPO FORM P0459

For more details about this annex : see Official Journal of the European Patent Office, No. 12/82